# EUROPEAN PATENT SPECIFICATION

(11) **EP 3 702 387 B1**
(45) Date of publication and mention of the grant of the patent: **10.05.2023**
(21) Application number: 20159057.7
(22) Date of filing: 24.02.2020
(51) Int. Cl.: C08G 59/00, C08G 2/00, C08G 59/40, C08G 65/18, G03C 1/73, G03F 7/039, H01L 21/027

(54) **PHOTOSENSITIVE RESIN COMPOSITION, AND METHOD FOR ETCHING GLASS SUBSTRATE**
LICHTEMPFINDLICHE HARZZUSAMMENSETZUNG UND VERFAHREN ZUM ÄTZEN VON GLASSUBSTRATEN
COMPOSITION DE RÉSINE PHOTOSENSIBLE ET PROCÉDÉ DE GRAVURE DE SUBSTRAT DE VERRE

(30) Priority: 28.02.2019 JP 2019036725; 30.08.2019 JP 2019158539
(43) Date of publication of application: 02.09.2020
(73) Proprietor: TOKYO OHKA KOGYO CO., LTD., Kawasaki-shi, Kanagawa 211 0012 (JP)
(72) Inventor: UEMATSU, Teruhiro, Kanagawa 211-0012 (JP)
(74) Representative: Plasseraud IP

(56) References cited:
- JP-A- 2004 330 269
- JP-A- 2008 096 717
- JP-A- 2009 157 225
- JP-A- 2009 157 235
- JP-A- 2009 237 412
- US-A1- 2006 003 260
- US-B1- 6 338 936

## Description

This application is based on and claims the benefit of priority from Japanese Patent Application Nos. 2019-036725 and 2019-158539, respectively filed on 28 February 2019 and 30 August 2019.

### BACKGROUND OF THE INVENTION

### Field of the Invention

The present invention relates to a photosensitive resin composition as defined in the appended set of claims to be used for forming an etching mask on a glass substrate and a method for etching a glass substrate, the method including forming an etching mask on a glass substrate using the photosensitive resin composition.

### Related Art

A glass substrate for a display including a glass substrate for a touch panel, a glass substrate for a package device, and the like, are often subjected to processing such as cutting and hole formation. Conventionally, a physical method has been generally used as a processing method of a glass substrate. However, in the physical processing of a glass substrate, there are problems that a glass substrate easily cracks at the time of processing and that the yield is reduced due to reduction of strength of the glass substrate.

Then, recently, a chemical method for etching processing of a glass substrate using a resin pattern obtained by patterning a resist composition as a mask has been proposed (see, for example, Patent Document 1). With such a chemical method, since a physical load is not applied during processing, a glass substrate is not easily cracked.

In such an etching processing method of a glass substrate, since it is easy to form an etching mask having high resistance to an etchant used for etching a glass substrate and having excellent adherence to a glass substrate, as described in Patent Document 1, an etching mask patterned through curing by exposing a negative-type photosensitive composition including a radical polymerizable compound, an epoxy compound, and the like, is formed in many cases.

Patent Document 1: Japanese Unexamined Patent Application, Publication No. 2008-076768.

JP 2004 330269 A relates to an insulating resin composition.

JP 2009 237412 A, JP 2009 157235 A, JP 2009 157225 A, and US 6 338 936 B1 relate to photosensitive resin compositions. JP 2008 096717 A and US 2006/003260 A1 relate to chemically amplified positive photoresist composition.

### SUMMARY OF THE INVENTION

A glass substrate to be etching-processed is often provided with metal wiring, and a resin layer made of resin such as polyimide. Furthermore, as described in Patent Document 1, when an etching mask patterned using a negative-type photosensitive composition is formed, an alkaline stripping liquid is usually used in peeling off an etching mask from the glass substrate. However, when an alkaline stripping liquid is used, a glass substrate itself or metal wiring or resin material of the glass substrate is easily damaged.

The present invention is as defined in the appended set of claims. The present invention has been made in view of the above-mentioned problem. An object of the present invention is to provide a photosensitive resin composition as defined in the appended set of claims having sufficient resistance to an etchant used for etching of a glass substrate and being capable of forming an etching mask that can be peeled off with an organic solvent-based stripping liquid, and a method for etching a glass substrate, the method including forming an etching mask using the photosensitive resin composition as defined in the appended set of claims.

The present inventors have found that the above-mentioned problem can be solved by using, for forming an etching mask in etching of a glass substrate, a photosensitive resin composition as defined in the appended set of claims including a resin component (A) having an acid-dissociable dissolution-inhibiting group and having a solubility in alkali to be increased by an action of an acid, an acid generator (B) to generate an acid by irradiation with radiation, a filler (C), and a plasticizer (D), and have completed the present invention. More specifically, the present invention provides the following.

A first aspect of the present invention is a photosensitive resin composition as defined in the appended set of claims including a resin component (A) having an acid-dissociable dissolution-inhibiting group and having a solubility in alkali to be increased by an action of an acid, an acid generator (B) to generate an acid by irradiation with radiation, a filler (C), and a plasticizer (D), wherein the resin component (A) is a novolac resin in which at least a part of the phenolic hydroxyl group is protected by the acid-dissociable dissolution-inhibiting group, the resin component (A) comprises a reacted product of the novolac resin and a compound represented by the formula (I),the formula (I) is represented by the following formula:

H₂C=CH-O-A^{a1}-O-CH=CH₂ ... (I)

wherein, in the formula (I), A^{a1} is an alkylene group having 1 or more and 10 or less carbon atoms, optionally having a substituent and optionally having an ether bond in a main chain, or a group represented by the following formula (II):

-(A^{a2})ₙₐ-A^{a3}-(A^{a2})ₙₐ- ... (II)

wherein, in the formula (II), A^{a2} is an alkylene group having 1 or more and 10 or less carbon atoms, and optionally having a substituent, A^{a3} is a cyclohexylene group, and na is 0 or 1, the filler (C) comprises an inorganic filler or an organic filler, and the plasticizer (D) comprises a polyvinylalkyl ether.

A second aspect of the present invention is a method as defined in the appended set of claims for etching a glass substrate, the method including: a coating film formation step of applying a photosensitive resin composition according to the above-mentioned first aspect of the present invention to at least one of main surfaces of the glass substrate to form a coating film on the main surface of the glass substrate; an exposure step of exposing the coating film in a position-selective manner; an etching mask formation step of developing the exposed coating film with a developing solution to form an etching mask; an etching step of subjecting the glass substrate provided with the etching mask to etching processing; and a removing step of removing the etching mask.

The present invention can provide a photosensitive resin composition as defined in the appended set of claims capable of forming an etching mask having sufficient resistance to an etchant to be used for etching of a glass substrate, the mask being able to be peeled off by an organic solvent-based stripping liquid, and a method for etching a glass substrate, the method including forming an etching mask using the photosensitive resin composition.

### DETAILED DESCRIPTION

### <<Photosensitive resin composition>>

A photosensitive resin composition may be or not may be a composition used for forming an etching mask on a glass substrate, but it is preferably a composition used for forming an etching mask on the glass substrate. The photosensitive resin composition as defined in the appended set of claims includes a resin component (A) having an acid-dissociable dissolution-inhibiting group and having a solubility in alkali to be increased by an action of an acid, an acid generator (B) to generate an acid by irradiation with radiation, a filler (C), and a plasticizer (D). According to an embodiment of the present disclosure not falling within the subject-matter of the appended set of claims, the photosensitive resin compositionincludes a resin component (A1) having a phenolic hydroxyl group, a protective agent (A2) to give an acid-dissociable dissolution-inhibiting group by reacting with a phenolic hydroxyl group, the acid generator (B), the filler (C), and the plasticizer (D). Hereinafter, the photosensitive resin composition including the resin component (A), acid the generator (B), the filler (C), and the plasticizer (D) is referred to as a first photosensitive resin composition. Furthermore, the photosensitive resin composition including a resin component (A1) having a phenolic hydroxyl group, a protective agent (A2) giving an acid-dissociable dissolution-inhibiting group by reacting with a phenolic hydroxyl group, the acid generator (B), the filler (C), and the plasticizer (D), not falling within the subject-matter of the appended set of claims, is referred to as a second photosensitive resin composition.

### <First photosensitive resin composition>

As described above, the first photosensitive resin composition includes the resin component (A), the acid generator (B), the filler (C), and the plasticizer (D) mentioned above. Hereinafter, essential or optional components of the first photosensitive resin composition are described.

### [Resin component (A)]

A resin component (A) as defined in the appended set of claims is a novolac resin in which at least a part of a phenolic hydroxyl group is protected by an acid-dissociable dissolution-inhibiting group.
In an embodiment of the present disclosure not falling within the subject-matter of the appended set of claims, a resin component (A) is a polyhydroxystyrene resin in which at least a part of a phenolic hydroxyl group is protected by an acid-dissociable dissolution-inhibiting group.

As the resin component (A), when a resin derived from an aromatic skeleton-containing novolac resin or a polyhydroxystyrene resin is used, an etching mask formed using the first photosensitive resin composition is excellent in resistance to an etchant such as an aqueous solution of hydrofluoric acid.

From the viewpoint that excellent resistance of an etching mask to an etchant and easiness in peeling of the etching mask by an organic solvent are particularly both achieved, the resin component (A) as defined in the appended set of claims includes a reacted product of a novolac resin and a divinyl ether compound represented by the below-mentioned formula (I). In an embodiment of the present disclosure not falling within the subject-matter of the appended set of claims, the resin component (A) as defined in the appended set of claims includes a reacted product of a polyhydroxystyrene resin and a divinyl ether compound represented by the below-mentioned formula (I).

In the reacted product of a novolac resin or a polyhydroxystyrene resin and a divinyl ether compound represented by the below-mentioned formula (I), molecules of the novolac resin or the polyhydroxystyrene resin are crosslinked by a divalent acid-dissociable dissolution-inhibiting group by the reaction of the phenolic hydroxyl group and the divinyl ether compound represented by the formula (I).

Hereinafter, a novolac resin protected by an acid-dissociable dissolution-inhibiting group falling within the subject-matter of the appended set of claims and a polyhydroxystyrene resin protected by an acid-dissociable dissolution-inhibiting group not falling within the subject-matter of the appended set of claims will be described.

### (Novolac resin)

A novolac resin protected by an acid-dissociable dissolution-inhibiting group is a novolac resin in which at least a part of the phenolic hydroxyl group is protected by an acid-dissociable dissolution-inhibiting group. The novolac resin in which a hydroxyl group is protected by an acid-dissociable dissolution-inhibiting group is not particularly limited and can be appropriately selected from well-known novolac resins. For example, as the novolac resin protected by an acid-dissociable dissolution-inhibiting group, a resin including a constituent unit having a phenolic hydroxyl group protected by an acid-dissociable dissolution-inhibiting group represented by the following formula (a1) can be used.

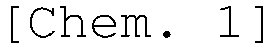

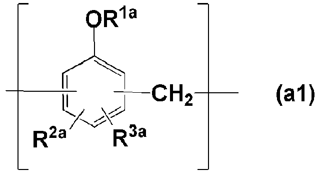

In the above formula (a1), R^{1a} represents an acid-dissociable dissolution-inhibiting group, and R^{2a} and R^{3a} each independently represent a hydrogen atom or an alkyl group having 1 or more and 6 or less carbon atoms.

The acid-dissociable dissolution-inhibiting group represented by R^{1a} is preferably groups represented by the following formulae (a2) and (a3), a linear, branched, or cyclic alkyl group having 1 or more and 6 or less carbon atoms, a vinyloxy ethyl group, a tetrahydropyranyl group, a tetrahydrofuranyl group, or a trialkylsilyl group.

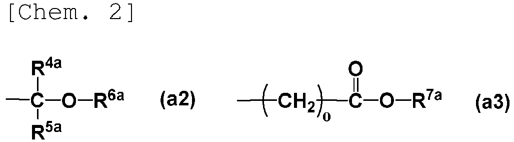

In the above formulae (a2) and (a3), R^{4a} and R^{5a} each independently represent a hydrogen atom or a linear or branched alkyl group having 1 or more and 6 or less carbon atoms, R^{6a} represents a linear, branched, or cyclic alkyl group having 1 or more and 10 or less carbon atoms, R^{7a} represents a linear, branched, or cyclic alkyl group having 1 or more and 6 or less carbon atoms, and o represents 0 or 1.

Examples of the above linear or branched alkyl group include a methyl group, an ethyl group, a propyl group, an isopropyl group, an n-butyl group, an isobutyl group, a tert-butyl group, a pentyl group, an isopentyl group, a neopentyl group, and the like. Furthermore, examples of the above cyclic alkyl group include a cyclopentyl group, a cyclohexyl group, and the like.

Herein, specific examples of the acid-dissociable dissolution-inhibiting group represented by the above formula (a2) include a methoxyethyl group, an ethoxyethyl group, an n-propoxyethyl group, an isopropoxyethyl group, an n-butoxyethyl group, an isobutoxyethyl group, a tert-butoxyethyl group, a cyclohexyloxyethyl group, a methoxypropyl group, an ethoxypropyl group, a 1-methoxy-1-methyl-ethyl group, a 1-ethoxy-1-methylethyl group, and the like. Furthermore, specific examples of the acid-dissociable dissolution-inhibiting group represented by the above formula (a3) include a tert-butoxycarbonyl group, a tert-butoxycarbonylmethyl group, and the like. Furthermore, examples of the above trialkylsilyl group include a trimethylsilyl group and a tri-tert-butyldimethylsilyl group in which each alkyl group has 1 or more and 6 or less carbon atoms.

As described above, from the viewpoint that excellent resistance of an etching mask to an etchant and easiness in peeling of the etching mask with an organic solvent are particularly both achieved, the acid-dissociable dissolution-inhibiting group is a divalent acid-dissociable dissolution-inhibiting group derived from a divinyl ether compound represented by the formula (I).

H₂C=CH-O-A^{a1}-O-CH=CH₂ ... (I)

In the formula (I), A^{a1} is an alkylene group having 1 or more and 10 or less carbon atoms, optionally having a substituent and optionally including an ether bond in the main chain, or a group represented by the following formula (II):

-(A^{a2})ₙₐ-A^{a3}-(A^{a2})ₙₐ- ... (II),

wherein, in the formula (II), A^{a2} is an alkylene group having 1 or more and 10 or less carbon atoms, optionally having substituent; A^{a3} is a cyclohexylene group; and na is 0 or 1.

When both ends of the divinyl ether compound represented by the formula (I) are reacted with two of the phenolic hydroxyl groups of the novolac resin, a divalent acid-dissociable dissolution-inhibiting group derived from the divinyl ether compound represented by the formula (I) is generated. The divalent acid-dissociable dissolution-inhibiting group derived in the divinyl ether compound represented by the formula (I) is a group represented by the following formula (Ia).

-CH(CH₃)-O-A^{a1}-O-CH(CH₃)- . . . (Ia)

Furthermore, when only one end of the divinyl ether compound represented by the formula (I) is reacted with a phenolic hydroxyl group of the novolac resin, a monovalent acid-dissociable dissolution-inhibiting group represented by the following formula (Ib) is generated.

-CH(CH₃)-O-A^{a1}-O-CH=CH₂ . . . (Ib)

A^{a1} in the formulae (Ia) and (Ib) is the same as A^{a1} in the formula (I).

When A^{a1} in the formula (I) is an alkylene group having 1 or more and 10 or less carbon atoms, optionally having a substituent and optionally including an ether bond in the main chain, examples of the substituent which an alkylene group may have include halogen atoms such as a chlorine atom, a bromine atom, and a fluorine atom, and alkoxy groups such as a methoxy group and an ethoxy group.

The alkylene group as A^{a1} in the formula (I) may include an ether bond (-O-) in the chain. When A^{a1} is an alkylene group optionally having an ether bond in the chain, the number of carbon atoms is 1 or more and 10 or less, preferably 1 or more and 8 or less, and more preferably 2 or more and 6 or less. Suitable specific examples of the alkylene group as A^{a1} optionally having an ether bond in the main chain include - CH₂CH₂CH₂CH₂-, -CH₂CH₂-O-CH₂CH₂-, and -CH₂CH₂-O-CH₂CH₂-O-CH₂CH₂.

A divalent group represented by the above formula (II) is also preferable as A^{a1}. In the formula (II), A^{a3} is a cyclohexylene group. The cyclohexylene group may be any of a cyclohexane-1,4-diyl group, a cyclohexane-1,3-diyl group, and a cyclohexane-1,2-diyl group, and a cyclohexane-1,4-diyl group is preferable. In the formula (II), na is independently 0 or 1. In the formula (II), A^{a2} is an alkylene group having 1 or more and 10 or less carbon atoms, optionally having a substituent. The number of carbon atoms of the alkylene group as A^{a2} is preferably 1 or more and 6 or less, more preferably 1 or more and 4 or less, and further preferably 1 or 2. Examples of the substituent which the alkylene group as A^{a2} may have include halogen atoms such as a chlorine atom, a bromine atom, and a fluorine atom, and alkoxy groups such as a methoxy group and an ethoxy group. Suitable specific examples of the alkylene group as A^{a2} include a methylene group, an ethane-1,2-diyl group, an ethane-1,1-diyl group, a propane-1,3-diyl group, a butane-1,4-diyl group, and the like.

Particularly preferable examples of the divalent group represented by the formula (II) include a group in which both of the two na are 1, A^{a3} is a cyclohexane-1,4-diyl group, and two A^{a2} are a methylene group.

The ratio (protection ratio) of the number of hydroxyl groups protected by the acid-dissociable dissolution-inhibiting group derived from the divinyl ether compound represented by the formula (I), which is represented by the above formula (Ia) and/or the formula (Ib), to the number of all the phenolic hydroxyl group of the novolac resin is preferably in the rate of 0.50 or more and 300 or less, preferably in the rate of 1% or more and 200 or less, and further preferably 2% or more and 10% or less, from the viewpoint of film characteristics of the etching mask. The protection ratio can be verified by, for example, proton NMR.

### [Polyhydroxystyrene resin]

A polyhydroxystyrene resin protected by an acid-dissociable dissolution-inhibiting group is a polyhydroxystyrene resin in which at least a part of the phenolic hydroxyl group is protected by the acid-dissociable dissolution-inhibiting group. The polyhydroxystyrene resin in which the hydroxyl group is protected by the acid-dissociable dissolution-inhibiting group is not particularly limited and can be appropriately selected from well-known polyhydroxystyrene resins. For example, as the polyhydroxystyrene resin protected by the acid-dissociable dissolution-inhibiting group, a resin including a constituent unit having a phenolic hydroxyl group protected by an acid-dissociable dissolution-inhibiting group represented by the following formula (a4) can be used.

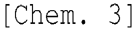

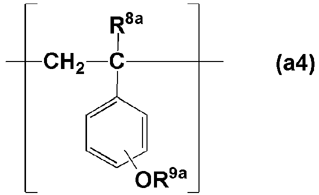

In the above formula (a4), R^{8a} represents a hydrogen atom or an alkyl group having 1 or more and 6 or less carbon atoms; and R^{9a} represents an acid-dissociable dissolution-inhibiting group.

The above-mentioned alkyl group having 1 or more and 6 or less carbon atoms is, for example, a linear, branched, or cyclic alkyl group having 1 or more and 6 or less carbon atoms. Examples of the linear or branched alkyl group include a methyl group, an ethyl group, a propyl group, an isopropyl group, an n-butyl group, an isobutyl group, a tert-butyl group, a pentyl group, an isopentyl group, a neopentyl group, and the like.

As the acid-dissociable dissolution-inhibiting group represented by the above R^{9a}, an acid-dissociable dissolution-inhibiting group that is the same as the groups represented by the above formulae (a2) and (a3) can be used.

In addition, the polyhydroxystyrene resin can include a constituent unit derived from another polymerizable compound in order to moderately control physical or chemical properties. The polymerizable compound is exemplified by well-known radical polymerizable compounds and anion polymerizable compounds. Examples of the polymerizable compound include monocarboxylic acids such as acrylic acid, methacrylic acid, and crotonic acid; dicarboxylic acids such as maleic acid, fumaric acid, and itaconic acid; methacrylic acid derivatives having a carboxy group and an ester bond such as 2-methacryloyloxyethyl succinic acid, 2-methacryloyloxyethyl maleic acid 2-methacryloyloxyethyl phthalic acid, and 2-methacryloyloxyethyl hexahydrophthalic acid; (meth)acrylic acid alkyl esters such as methyl(meth)acrylate, ethyl (meth)acrylate, and butyl (meth)acrylate; (meth)acrylic acid hydroxyalkyl esters such as 2-hydroxyethyl (meth)acrylate and 2-hydroxypropyl (meth)acrylate; (meth)acrylic acid aryl esters such as phenyl (meth)acrylate and benzyl (meth)acrylate; dicarboxylic acid diesters such as diethyl maleate and dibutyl fumarate; vinyl group-containing aromatic compounds such as styrene, α-methylstyrene, chlorostyrene, chloromethylstyrene, vinyltoluene, hydroxystyrene, α-methylhydroxystyrene, and α-ethylhydroxystyrene; vinyl group-containing aliphatic compounds such as vinyl acetate; conjugated diolefins such as butadiene and isoprene; nitrile group-containing polymerizable compounds such as acrylonitrile and methacrylonitrile; chlorine-containing polymerizable compounds such as vinyl chloride and vinylidene chloride; and amide bond-containing polymerizable compounds such as acrylamide and methacrylamide. The mass average molecular weight of the resin component (A) is preferably 1000 or more and 60000 or less, and more preferably 2000 or more and 50000 or less. The resin component (A) may be a single component or may be a combination of two or more components. The content of the resin component (A) is preferably 5% by mass or more and 90% by mass or less, 15% by mass or more and 80% by mass or less, and further preferably 30% by mass or more and 70% by mass or less with respect to the solid content (excluding a solvent) of a first radiation sensitive composition.

### [Acid generator (B)]

An acid generator (B) is a compound capable of generating an acid by irradiation with radiation. The acid generator (B) is not particularly limited as long as it is a compound which directly or indirectly generates an acid under the action of light. The acid generator (B) is preferably any one of the first to fifth acid generators that will be described below. Hereinafter, the first to fifth acid generators will be described.

### (First acid generator)

Examples of a first acid generator include the compound represented by the following formula (b1).

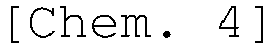

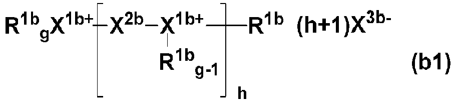

In the above formula (b1), X^{1b} represents a sulfur atom or iodine atom respectively having a valence of g, and g is 1 or 2. h represents the number of repeating units in the structure within parentheses. R^{1b} represents an organic group that is bonded to X^{1b}, and represents an aryl group having 6 or more and 30 or less carbon atoms, a heterocyclic group having 4 or more and 30 or less carbon atoms, an alkyl group having 1 or more and 30 or less carbon atoms, an alkenyl group having 2 or more and 30 or less carbon atoms or an alkynyl group having 2 or more and 30 or less carbon atoms; and R^{1b} may be substituted with at least one selected from the group consisting of an alkyl group, a hydroxyl group, an alkoxy group, an alkylcarbonyl group, an arylcarbonyl group, an alkoxycarbonyl group, an aryloxycarbonyl group, an arylthiocarbonyl group, an acyloxy group, an arylthio group, an alkylthio group, an aryl group, a heterocyclic group, an aryloxy group, an alkylsulfinyl group, an arylsulfinyl group, an alkylsulfonyl group, an arylsulfonyl group, an alkyleneoxy group, an amino group, a cyano group, a nitro group, and halogen atoms. The number of R^{1b}s is g + h(g - 1) + 1, and the R^{1b}s may be the same as or different from each other. Furthermore, two or more R^{1b}s may be bonded to each other directly or via -O-, -S-, -SO-, -SO₂-, -NH-, -NR^{2b}-, -CO-, - COO-, -CONH-, an alkylene group having 1 or more and 3 or less carbon atoms or a phenylene group, and may form a ring structure including X^{1b}. R^{2b} is an alkyl group having 1 or more and 5 or less carbon atoms or an aryl group having 6 or more and 10 or less carbon atoms.

X^{2b} is a structure represented by the following formula (b2) .

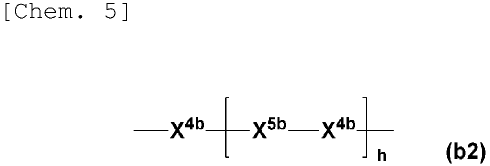

In the above formula (b2), X^{4b} represents an alkylene group having 1 or more and 8 or less carbon atoms, an arylene group having 6 or more and 20 or less carbon atoms, or a divalent group of a heterocyclic compound having 8 or more and 20 or less carbon atoms, and X^{4b} may be substituted with at least one selected from the group consisting of an alkyl group having 1 or more and 8 or less carbon atoms, an alkoxy group having 1 or more and 8 or less carbon atoms, an aryl group having 6 or more and 10 or less carbon atoms, a hydroxyl group, a cyano group, a nitro group, and halogen atoms. X^{5b} represents -O-, -S-, -SO-, -SO₂-, -NH-, -NR^{2b}-, -CO-, -COO-, - CONH-, an alkylene group having 1 or more and 3 or less carbon atoms, or a phenylene group. h represents the number of repeating units of the structure in parentheses and is an integer of 0 or more. X^{4b}s in the number of h + 1 and X^{5b}s in the number of h may be identical to or different from each other. R^{2b} has the same definition as described above.

X^{3b-} is a counterion of an onium, and examples thereof include a fluorinated alkylfluorophosphoric acid anion represented by the following formulae (b9), (b13), (b14), and (b17), or a borate anion represented by the following formula (b18). From the viewpoint of film characteristics of the etching mask, anion represented by the following formula (b9) is preferable.

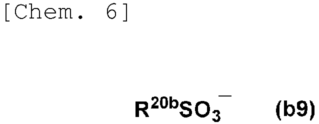

In the above formula (b9), R^{20b} is a group represented by the following formulae (b10), (b11), and (b12).

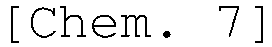

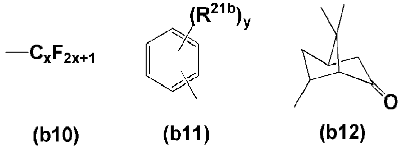

In the above formula (b10), x represents an integer of 1 or more and 4 or less. Furthermore, in the above formula (b11), R^{21b} represents a hydrogen atom, a hydroxyl group, a linear or branched alkyl group having 1 or more and 6 or less carbon atoms, or a linear or branched alkoxy group having 1 or more and 6 or less carbon atoms, and y represents an integer of 1 or more and 3 or less. Among them, from the viewpoint of safety, trifluoromethane sulfonate and perfluorobutane sulfonate are preferable.

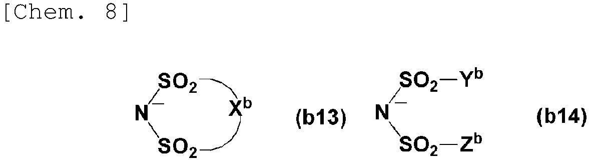

In the above formulae (b13) and (b14), X^{b} is a linear or branched alkylene group in which at least one hydrogen atom is substituted with a fluorine atom, and the number of carbon atoms of the alkylene group is 2 or more and 6 or less, preferably 3 or more and 5 or less, and most preferably 3. Furthermore, Y^{b} and Z^{b} are each independently linear or branched alkyl group in which at least one hydrogen atom is substituted with a fluorine atom, and the number of carbon atoms of the alkyl group is 1 or more and 10 or less, preferably 1 or more and 7 or less, and more preferably 1 or more and 3 or less.

A smaller number of carbon atoms in the alkylene group of X^{b} or in the alkyl group of Y^{b} or Z^{b} is preferable because the solubility into an organic solvent is also favorable.

Furthermore, a larger number of hydrogen atoms each substituted by a fluorine atom in the alkylene group of X^{b} or in the alkyl group of Y^{b} or Z^{b} is preferable because the acid strength becomes greater. The rate of the fluorine atom alkylene group or the alkyl group, that is, the fluorination rate, is preferably 700 or more and 100% or less, more preferably 90% or more and 100% or less, and most preferably a perfluoroalkylene group or a perfluoroalkyl group in which all of the hydrogen atoms are substituted with fluorine atoms.

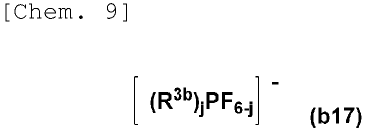

In the above formula (b17), R^{3b} represents an alkyl group having 80% or more of the hydrogen atoms substituted by fluorine atoms. j represents the number thereof and is an integer of 1 or more and 5 or less. (j) R^{3b}s may be respectively identical to or different from each other.

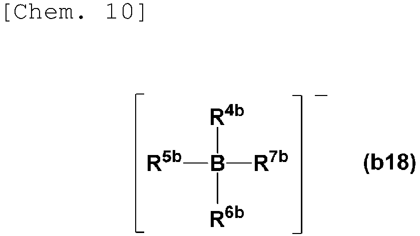

In the above formula (a18), R^{4b} to R^{7b} each independently represents a fluorine atom or a phenyl group, and a part or all of the hydrogen atoms of the phenyl group may be substituted with at least one selected from the group consisting of a fluorine atom and a trifluoromethyl group.

Examples of the onium ion in the compound represented by the above formula (b1) include triphenylsulfonium, tri-p-tolylsulfonium, 4-(phenylthio)phenyldiphenylsulfonium, bis[4-(diphenylsulfonio)phenyl] sulfide, bis[4-{bis[4-(2-hydroxyethoxy)phenyl]sulfonio}phenyl] sulfide, bis{4-[bis(4-fluorophenyl)sulfonio]phenyl} sulfide, 4-(4-benzoyl-2-chlorophenylthio)phenylbis(4-fluorophenyl)sulfonium, 7-isopropyl-9-oxo-10-thia-9,10-dihydroanthran-2-yldi-p-tolylsulfonium, 7-isopropyl-9-oxo-10-thia-9,10-dihydroanthracen-2-yldiphenylsulfonium, 2-[(diphenyl)sulfonio]thioxanthone, 4-[4-(4-tert-butylbenzoyl)phenylthio]phenyldi-p-tolylsulfonium, 4-(4-benzoylphenylthio)phenyldiphenylsulfonium, diphenylphenacylsulfonium, 4-hydroxyphenylmethylbenzylsulfo-nium, 2-naphthylmethyl(1-ethoxycarbonyl)ethylsulfonium, 4-hydroxyphenylmethylphenacylsulfonium, phenyl[4-(4-biphenylthio)phenyl]-4-biphenylsulfonium, phenyl[4-(4-biphenylthio)phenyl]-3-biphenylsulfonium, [4-(4-acetophenylthio)phenyl]diphenylsulfonium, octadecylmethylphenacylsulfonium, diphenyliodonium, di-p-tolyliodonium, bis(4-dodecylphenyl)iodonium, bis(4-methoxyphenyl)iodonium, (4-octyloxyphenyl)phenyliodonium, bis(4-decyloxy)phenyliodonium, 4-(2-hydroxytetradecyloxy)phenylphenyliodonium, 4-isopropylphenyl(p-tolyl)iodonium, 4-isobutylphenyl(p-tolyl)iodonium, or the like.

In regard to the fluorinated alkylfluorophosphoric acid anion represented by the above formula (b17), R^{3b} represents an alkyl group substituted with a fluorine atom, and a preferable number of carbon atoms is 1 or more and 8 or less, while a more preferable number of carbon atoms is 1 or more and 4 or less. Specific examples of the alkyl group include: linear alkyl groups such as methyl, ethyl, propyl, butyl, pentyl and octyl; branched alkyl groups such as isopropyl, isobutyl, secbutyl and tert-butyl; and furthermore, cycloalkyl groups such as cyclopropyl, cyclobutyl, cyclopentyl and cyclohexyl, and the proportion of hydrogen atoms substituted by fluorine atoms in the alkyl groups is normally 800 or more, is preferably 900 or more and is more preferably 100%. When the substitution rate of fluorine atoms is less than 800, the acid strength of the onium fluorinated alkylfluorophosphate represented by the above formula (b1) is lowered.

A particularly preferable example of R^{3b} is a linear or branched perfluoroalkyl group having 1 or more and 4 or less carbon atoms and a substitution ratio of fluorine atoms of 100%. Specific examples thereof include CF₃, CF₃CF₂, (CF₃)₂CF, CF₃CF₂CF₂, CF₃CF₂CF₂CF₂, (CF₃)₂CFCF₂, CF₃CF₂(CF₃) CF, (CF₃)₃C, and the like. j which is the number of R^{3b}s represents an integer from 1 or more and 5 or less, and is preferably 2 or more and 4 or less, and particularly preferably 2 or 3.

Preferable specific examples of the fluorinated alkylfluorophosphoric acid anion include [(CF₃CF₂)₂PF₄]⁻, [(CF₃CF₂)₃PF₃]⁻, [((CF₃)₂CF)₂PF₄]⁻, [((CF₃)₂CF)₃PF₃]⁻, [(CF₃CF₂CF₂)₂PF₄]⁻, [(CF₃CF₂CF₂)₃PF₃]⁻, [((CF₃)₂CFCF₂)₂PF₄]⁻, [((CF₃)₂CFCF₂)₃PF₃]⁻, [(CF₃CF₂CF₂CF₂)₂PF₄]⁻, or [(CF₃CF₂CF₂)₃PF₃]⁻. Among them, [(CF₃CF₂)₃PF₃]⁻, [(CF₃CF₂CF₂)₃PF₃]⁻, [((CF₃)₂CF)₃PF₃]⁻, [((CF₃)₂CF)₂PF₄]⁻, [((CF₃)₂CFCF₂)₃PF₃]⁻, or [((CF₃)₂CFCF₂)₂PF₄]⁻ is particularly preferable.

Preferable specific examples of the borate anion represented by the above formula (b18) include tetrakis (pentafluorophenyl) borate ([B(C₆F₅)₄]⁻), tetrakis [(trifluoromethyl)phenyl]borate ([B(C₆H₄CF₃)₄]⁻), difluorobis (pentafluorophenyl) borate ([(C₆F₅)₂BF₂]⁻), trifluoro (pentafluorophenyl) borate ([(C₆F₅)BF₃]⁻), and tetrakis (difluorophenyl) borate ([B(C₆H₃F₂)₄]⁻). Among these, tetrakis (pentafluorophenyl) borate ([B(C₆F₅)₄]⁻) is particularly preferable.

### (Second acid generator)

The second acid generator includes halogen-containing triazine compounds such as 2,4-bis(trichloromethyl)-6-piperonyl-1,3,5-triazine, 2,4-bis(trichloromethyl)-6-[2-(2-furyl)ethenyl]-s-triazine, 2,4-bis(trichloromethyl)-6-[2-(5-methyl-2-furyl)ethenyl]-s-triazine, 2,4-bis(trichloromethyl)-6-[2-(5-ethyl-2-furyl)ethenyl]-s-triazine, 2,4-bis(trichloromethyl)-6-[2-(5-propyl-2-furyl)ethenyl]-s-triazine, 2,4-bis(trichloromethyl)-6-[2-(3,5-dimethoxyphenyl)ethenyl]-s-triazine, 2,4-bis(trichloromethyl)-6-[2-(3,5-diethoxyphenyl)ethenyl]-s-triazine, 2,4-bis(trichloromethyl)-6-[2-(3,5-dipropoxyphenyl)ethenyl]-s-triazine, 2,4-bis(trichloromethyl)-6-[2-(3-methoxy-5-ethoxyphenyl)ethenyl]-s-triazine, 2,4-bis(trichloromethyl)-6-[2-(3-methoxy-5-propoxyphenyl)ethenyl]-s-triazine, 2,4-bis(trichloromethyl)-6-[2-(3,4-methylenedioxyphenyl)ethenyl]-s-triazine, 2,4-bis(trichloromethyl)-6-(3,4-methylenedioxyphenyl)-s-triazine, 2,4-bis-trichloromethyl-6-(3-bromo-4-methoxy)phenyl-s-triazine, 2,4-bis-trichloromethyl-6-(2-bromo-4-methoxy)phenyl-s-triazine, 2,4-bistrichloromethyl-6-(2-bromo-4-methoxy)styrylphenyl-s-triazine, 2,4-bis-trichloromethyl-6-(3-bromo-4-methoxy)styrylphenyl-s-triazine, 2-(4-methoxyphenyl)-4,6-bis(trichloromethyl)-1,3,5-triazine, 2-(4-methoxynaphthyl)-4,6-bis(trichloromethyl)-1,3,5-triazine, 2-[2-(2-furyl)ethenyl]-4,6-bis(trichloromethyl)-1,3,5-triazine, 2-[2-(5-methyl-2-furyl)ethenyl]-4,6-bis(trichloromethyl)-1,3,5-triazine, 2-[2-(3,5-dimethoxyphenyl)ethenyl]-4,6-bis(trichloromethyl)-1,3,5-triazine, 2-[2-(3,4-dimethoxyphenyl)ethenyl]-4,6-bis(trichloromethyl)-1,3,5-triazine, 2-(3,4-methylenedioxyphenyl)-4,6-bis(trichloromethyl)-1,3,5-triazine, tris(1,3-dibromopropyl)-1,3,5-triazine, and tris(2,3-dibromopropyl)-1,3,5-triazine; and halogen-containing triazine compounds represented by the following formula (b3) such as tris(2,3-dibromopropyl) isocyanurate.

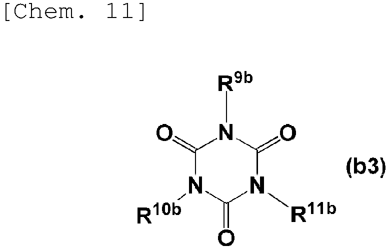

In the above formula (b3), R^{9b}, R^{10b}, and R^{11b} each independently represent a halogenated alkyl group.

### (Third acid generator)

The third acid generator includes α-(p-toluenesulfonyloxyimino)-phenylacetonitrile, α-(benzenesulfonyloxyimino)-2,4-dichlorophenylacetonitrile, α-(benzenesulfonyloxyimino)-2,6-dichlorophenylacetonitrile, α-(2-chlorobenzenesulfonyloxyimino)-4-methoxyphenylacetonitrile, and α-(ethylsulfonyloxyimino)-1-cyclopentenylacetonitrile and compounds represented by the following formula (b4) containing an oximesulfonate group.

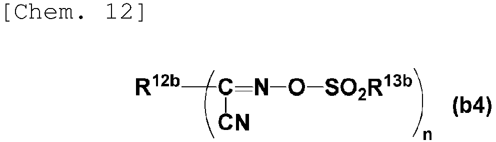

In the above formula (b4), R^{12b} represents a monovalent, divalent or trivalent organic group, R^{13b} represents a substituted or unsubstituted saturated hydrocarbon group, an unsaturated hydrocarbon group, or an aromatic group, and n represents the number of repeating units of the structure in the parentheses.

In the above formula (b4), examples of the aromatic group include aryl groups such as a phenyl group and a naphthyl group and heteroaryl groups such as a furyl group and a thienyl group. These groups may have one or more appropriate substituents such as a halogen atom, an alkyl group, an alkoxy group and a nitro group on the rings. Furthermore, R^{13b} is particularly preferably an alkyl group having 1 or more and 6 or less carbon atoms, and examples thereof include a methyl group, an ethyl group, a propyl group and a butyl group. In particular, compounds in which R^{12b} is an aromatic compound group and in which and R^{13b} is an alkyl group having 1 or more and 4 or less carbon atoms are preferable.

Examples of the acid generator represented by the above formula (b4) include compounds in which R^{12b} is any one of a phenyl group, a methylphenyl group and a methoxyphenyl group, and R^{13b} is a methyl group when n=1, and specific examples thereof include α-(methylsulfonyloxyimino)-1-phenylacetonitrile, α-(methylsulfonyloxyimino)-1-(p-methylphenyl)acetonitrile, α-(methylsulfonyloxyimino)-1-(p-methoxyphenyl)acetonitrile, [2-(propylsulfonyloxyimino)-2,3-dihydroxythiophene-3-ylidene](o-tolyl)acetonitrile, and the like. Specifically, when n = 2, the acid generator represented by the above formula (b4) is an acid generator represented by the following formulae.

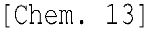

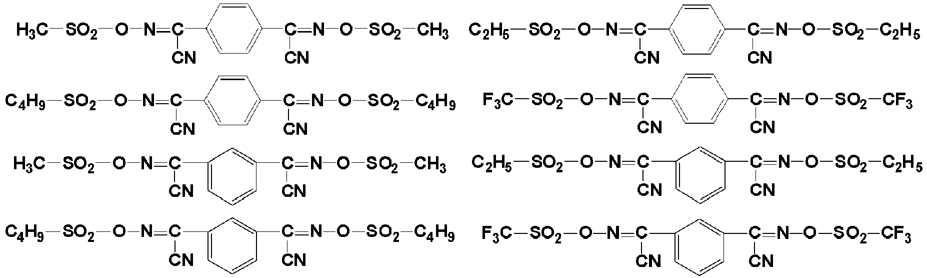

### (Fourth acid generator)

The fourth acid generator includes bissulfonyldiazomethanes such as bis(p-toluenesulfonyl)diazomethane, bis(1,1-dimethyl ethylsulfonyl)diazomethane, bis(cyclohexylsulfonyl)diazomethane and bis(2,4-dimethylphenylsulfonyl)diazomethane; nitrobenzyl derivatives such as 2-nitrobenzyl p-toluenesulfonate, 2,6-dinitrobenzyl p-toluenesulfonate, nitrobenzyl tosylate, dinitrobenzyl tosylate, nitrobenzyl sulfonate, nitrobenzyl carbonate and dinitrobenzyl carbonate; sulfonates such as pyrogalloltrimesylate, pyrogalloltritosylate, benzyltosylate, benzylsulfonate, N-methylsulfonyloxy succinimide, N-trichloromethylsulfonyloxy succinimide, N-phenylsulfonyloxy maleimide, and N-methylsulfonyloxy phthalimide; trifluoromethane sulfonates such as N-(trifluoromethylsulfonyloxy)phthalimide, N-(trifluoromethylsulfonyloxy)-1,8-naphthalimide, N-(trifluoromethylsulfonyloxy)-4-butyl-1,8-naphthalimide N-hydroxyphthalimide and N-hydroxynaphthalimide; onium salts such as diphenyliodonium hexafluorophosphate, (4-methoxyphenyl)phenyliodonium trifluoromethanesulfonate, bis(p-tert-butylphenyl)iodonium trifluoromethanesulfonate, triphenylsulfonium hexafluorophosphate, (4-methoxyphenyl)diphenylsulfonium trifluoromethanesulfonate, and (p-tert-butylphenyl)diphenylsulfonium trifluoromethanesulfonate; benzointosylates such as benzointosylate and α-methylbenzointosylate; other diphenyliodonium salts, triphenylsulfonium salts, phenyldiazonium salts, benzylcarbonates; and the like.

The acid generators (B) may be used alone, or two or more kinds may be used in combination. Furthermore, the content of the acid generator (B) is preferably 0.1 part by mass or more and 30 parts by mass or less, and particularly preferably 1 part by mass or more and 20 parts by mass or less when the (A) component of the photosensitive resin composition is 100 parts by mass. When the amount of acid generator (B) used is set within the range described above, it is easy to prepare the photosensitive resin composition having excellent sensitivity, being a uniform solution, and having excellent storage stability. When two types or more of acid generators (B) are combined, from the viewpoint of film characteristics of the etching mask, it is preferable to combine the first acid generator with one or more generators selected from the second to fourth acid generators, it is more preferable to combine the first acid generator with one generator selected from the second to fourth acid generators, and it is preferable to combine the first acid generator with the third acid generator. Furthermore, in the (B) component, the blending ratio (mass ratio) of the first acid generator to the other acid generator (one or more generators selected from the second to fourth acid generators) is preferably within the range of (first acid generator) to (other acid generator) = 99:1 to 1:99, more preferably 5:95 to 50:50, further preferably 10:90 to 40:60, and most preferably 10:90 to 30:70.

### [Filler (C)]

The photosensitive resin composition contains a filler (C). When the photosensitive resin composition includes the filler (C), an etching mask having excellent rigidity, mechanical property, heat resistance, and the like, can be easily formed using the photosensitive resin composition. The filler (C) may be an inorganic filler or an organic filler, and an inorganic filler is preferable. Since resistance to etchants such as hydrofluoric acid is high, examples of the filler (C) include mica, talc, clay, bentonite, montmorillonite, kaolinite, wollastonite, alumina, aluminum hydroxide, barium sulfate, barium titanate, potassium titanate, and the like.

The content of the filler (C) in the photosensitive resin composition is not particularly limited within a range where the objects of the present invention are not impaired. The content of the filler (C) in the photosensitive resin composition is appropriately determined in view of a film thickness of a formed etching mask, or a dipping depth of glass by etching, and the like. For example, the content of the filler (C) in the photosensitive resin composition is preferably 30 parts by mass or more and 70 parts by mass or less, and more preferably 35 parts by mass or more and 60 parts by mass or less relative to the total 100 parts by mass of the resin component (A) and the mass of the acid generator (B). In particular, in a case where the dipping depth of glass by etching is 300 µm or more, the content of the filler (C) is preferably within the above-mentioned range. Furthermore, in a case where the dipping depth of glass by etching is less than 300 um, the content of the filler (C) in the photosensitive resin composition may be 1 part by mass or more and less than 30 parts by mass, relative to the total 100 parts by mass of the resin component (A) and the mass of the acid generator (B) .

### [Plasticizer (D)]

The photosensitive resin composition includes a plasticizer (D). When the photosensitive resin composition includes the plasticizer (D), generation of cracks can be prevented in an etching mask formed by using the photosensitive resin composition. An etching mask free from cracks has excellent resistance to an etchant used in etching of the glass substrate.

Specific examples of the plasticizer (D) include polyvinyl chloride, polystyrene, polyhydroxystyrene, polyvinyl acetate, polyvinylbenzoic acid, polyvinylalkyl ether, polyvinyl alcohol, polyvinylpyrrolidone, polyvinyl phenol, copolymers thereof, and the like. Among them, polyvinylalkyl ether is preferable because an etching mask having excellent resistance to an etchant can be easily formed.

In an alkyl moiety of polyvinylalkyl ether, the number of carbon atoms is preferably 1 or more and 5 or less, and more preferably 1 or 2. In other words, as the polyvinylalkyl ether, polyvinyl methyl ether and polyvinyl ethyl ether are more preferable.

The mass average molecular weight of polyvinylalkyl ether is not particularly limited. The mass average molecular weight of polyvinylalkyl ether is preferably 10000 or more and 200000 or less, and more preferably 50000 or more and 100000 or less.

The content of the plasticizer (D) in the photosensitive resin composition is not particularly limited as long as a desired effect by the use of the plasticizer (D) is obtained. The content of the plasticizer (D) in the photosensitive resin composition is preferably 10 parts by mass or more and 100 parts by mass or less, more preferably 20 parts by mass or more and 80 parts by mass or less, and further preferably 30 parts by mass or more and 60 parts by mass or less relative to 100 parts by mass of the resin component (A).

### [Solvent (S)]

It is preferable that the photosensitive resin composition usually contains a (S) solvent for the purpose of, for example, adjusting the coating characteristics. The type of the solvent (S) is not particularly limited within a range where the objects of the present invention are not impaired and can be appropriately selected from solvents used for a positive-type photosensitive resin composition.

Specific examples of the solvent (S) includes: ketones such as acetone, methyl ethyl ketone, cyclohexanone, methyl isoamyl ketone, and 2-heptanone; glycols such as ethylene glycol diethylene glycol, triethylene glycol, propylene glycol, dipropylene glycol, tripropylene glycol, 1,3-butylene glycol, hexylene glycol; polyols such as glycerine; monools such as benzyl alcohol, and terpineol; glycol monoacetates such as ethylene glycol monoacetate, diethylene glycol monoacetate, triethylene glycol monoacetate, propylene glycol monoacetate, dipropylene glycol monoacetate, tripropylene glycol monoacetate, and 1,3-butylene glycol monoacetate; glycol diacetates such as ethylene glycol diacetate, diethylene glycol diacetate, triethylene glycol diacetate, propylene glycol diacetate, dipropylene glycol diacetate, tripropylene glycol diacetate, and 1,3-butylene glycol diacetate; glycol monoethers such as ethylene glycol monomethyl ether, ethylene glycol monoethyl ether, ethylene glycol monopropyl ether, ethylene glycol monobutyl ether, ethylene glycol monophenyl ether, diethylene glycol monomethyl ether, diethylene glycol monoethyl ether, diethylene glycol monopropyl ether, diethylene glycol monobutyl ether, diethylene glycol monophenyl ether, triethylene glycol monomethyl ether, triethylene glycol monoethyl ether, triethylene glycol monopropyl ether, triethylene glycol monobutyl ether, triethylene glycol monophenyl ether, propylene glycol monomethyl ether, propylene glycol monoethyl ether, propylene glycol monopropyl ether, propylene glycol monobutyl ether, propylene glycol monophenyl ether, dipropylene glycol monomethyl ether, dipropylene glycol monoethyl ether, dipropylene glycol monopropyl ether, dipropylene glycol monobutyl ether, dipropylene glycol monophenyl ether, tripropylene glycol monomethyl ether, tripropylene glycol monoethyl ether, tripropylene glycol monopropyl ether, tripropylene glycol monobutyl ether, tripropylene glycol monophenyl ether, 1,3-butylene glycol monomethyl ether, 1,3-butylene glycol monoethyl ether, 1,3-butylene glycol monopropyl ether, 1,3-butylene glycolmonobutyl ether, and 1,3-butylene glycol monophenyl ether; glycol monoether acetates such as ethylene glycol monomethyl ether acetate, ethylene glycol monoethyl ether acetate, ethylene glycol monopropyl ether acetate, ethylene glycol monobutyl ether acetate, ethylene glycol monophenyl ether acetate, diethylene glycol monomethyl ether acetate, diethylene glycol monoethyl ether acetate, diethylene glycol monopropyl ether acetate, diethylene glycol monobutyl ether acetate, diethylene glycol monophenyl ether acetate, triethylene glycol monomethyl ether acetate, triethylene glycol monoethyl ether acetate, triethylene glycol monopropyl ether acetate, triethylene glycol monobutyl ether acetate, triethylene glycol monophenyl ether acetate, propylene glycol monomethyl ether acetate, propylene glycol monoethyl ether acetate, propylene glycol monopropyl ether acetate, propylene glycol monobutyl ether acetate, propylene glycol monophenyl ether acetate, dipropylene glycol monomethyl ether acetate, dipropylene glycol monoethyl ether acetate, dipropylene glycol monopropyl ether acetate, dipropylene glycol monobutyl ether acetate, dipropylene glycol monophenyl ether acetate, tripropylene glycol monomethyl ether acetate, tripropylene glycol monoethyl ether acetate, tripropylene glycol monopropyl ether acetate, tripropylene glycol monobutyl ether acetate, tripropylene glycol monophenyl ether acetate, 1,3-butylene glycol monomethyl ether acetate(3-methoxybutyl acetate), 1,3-butylene glycolmonoethyl ether acetate, 1,3-butylene glycolmonopropyl ether acetate, 1,3-butylene glycolmonobutyl ether acetate, 1,3-butylene glycolmonophenyl ether acetate, 3-methyl-3-methoxybutyl acetate, 3-ethyl-3-methoxybutyl acetate, 2-methoxy pentyl acetate, 3-methoxy pentyl acetate, 4-methoxy pentyl acetate, 2-methyl-3-methoxy pentyl acetate, 3-methyl-3-methoxy pentyl acetate, 3-methyl-4-methoxy pentyl acetate, and 4-methyl-4-methoxy pentyl acetate; glycol diethers such as ethylene glycol dimethyl ether, ethylene glycol diethyl ether, ethylene glycol dipropyl ether, ethylene glycol dibutyl ether, ethylene glycol diphenyl ether, diethylene glycol dimethyl ether, diethylene glycol diethyl ether, diethylene glycol dipropyl ether, diethylene glycol dibutyl ether, diethylene glycol diphenyl ether, triethylene glycol dimethyl ether, triethylene glycol diethyl ether, triethylene glycol dipropyl ether, triethylene glycol dibutyl ether, triethylene glycol diphenyl ether, propylene glycol dimethyl ether, propylene glycol diethyl ether, propylene glycol dipropyl ether, propylene glycol dibutyl ether, propylene glycol diphenyl ether, dipropylene glycol dimethyl ether, dipropylene glycol diethyl ether, dipropylene glycol dipropyl ether, dipropylene glycol dibutyl ether, dipropylene glycol diphenyl ether, tripropylene glycol dimethyl ether, tripropylene glycol diethyl ether, tripropylene glycol dipropyl ether, tripropylene glycol dibutyl ether, tripropylene glycol diphenyl ether, 1,3-butylene glycol dimethyl ether, 1,3-butylene glycol diethyl ether, 1,3-butylene glycoldipropyl ether, 1,3-butylene glycoldibutyl ether, and 1,3-butylene glycol diphenyl ether; ethers such as dioxane and dihexyl ether; esters such as methyl formate, methyl lactate, ethyl lactate, methyl acetate, ethyl acetate, butyl acetate, benzyl acetate, ethyl benzoate, methyl pyruvate, methyl acetoacetate, ethyl acetoacetate, ethyl pyruvate, ethyl ethoxyacetate, methyl methoxypropionate, ethyl ethoxypropionate, 2-hydroxy methyl propionate, 2-hydroxy ethyl propionate, 2-hydroxy-2-methyl ethyl propionate, 2-hydroxy-3-methylbutanoic acid methyl, diethyl maleate, cyclohexanol acetate, and gamma butyrolactone; aromatic hydrocarbons such as toluene and xylene, and the like. These may be used alone, or two or more kinds may be used in mixture.

The photosensitive resin composition preferably includes a high boiling-point solvent (S1) having a boiling point of 170°C or more in the atmospheric pressure from the viewpoint of easiness in formation of a coating film having a uniform film thickness when the photosensitive resin composition is applied to the glass substrate. From the viewpoint of satisfactory solubility of each component included in the photosensitive resin composition and easiness of availability, and the like, preferable examples of the high boiling point solvents (S1) in the specific examples of the solvent (S) mentioned above include ethylene glycol, diethylene glycol, dipropylene glycol, hexylene glycol, glycerin, benzyl alcohol, terpineol, propylene glycol diacetate, 1,3-butylene glycol diacetate, diethylene glycol monomethyl ether, diethylene glycol monoethyl ether, diethylene glycol monopropyl ether, diethylene glycol monobutyl ether, diethylene glycol monophenyl ether, dipropylene glycol monomethyl ether, tripropylene glycol monomethyl ether, ethylene glycol monobutyl ether acetate, ethylene glycol monophenyl ether acetate, diethylene glycol monomethyl ether acetate, diethylene glycol monoethyl ether acetate, diethylene glycol monopropyl ether acetate, diethylene glycol monobutyl ether acetate, diethylene glycol monophenyl ether acetate, dipropylene glycol monomethyl ether acetate, 1,3-butylene glycol monomethyl ether acetate(3-methoxybutyl acetate), 3 methyl-3-methoxybutyl acetate, 3-ethyl-3-methoxybutyl acetate, 2-methoxypentyl acetate, 3-methoxypentyl acetate, 4-methoxypentyl acetate, 2-methyl-3-methoxypentyl acetate, 3-methyl-3-methoxypentyl acetate, 3-methyl-4-methoxypentyl acetate, and 4-methyl-4-methoxypentyl acetate, diethylene glycol diethyl ether, dipropylene glycol dimethyl ether, dihexyl ether benzyl acetate, ethyl benzoate, diethyl maleate, cyclohexanol acetate, gamma-butyrolactone, and the like.

The content of the high boiling-point solvent (S1) in the photosensitive resin composition is not particularly limited as long as a desired effect by the use of the high boiling-point solvent (S1) is obtained. The content of the high boiling-point solvent (S1) in the photosensitive resin composition is, from the viewpoint of the coating characteristics, preferably 1 part by mass or more and less than 50 parts by mass, and more preferably 1 part by mass or more and 20 parts by mass or less when the total mass of the solvent (S) in the photosensitive resin composition is 100 parts by mass. Furthermore, it is preferably 0.5% by mass or more and 20% by mass or less, more preferably 1% by mass or more and 15% by mass or less, and particularly preferably 2% by mass or more and 10% by mass or less with respect to the total mass of the photosensitive resin composition.

The content of the solvent (S) in the photosensitive resin composition is not particularly limited as long as an etching mask having a desired film thickness can be formed. The solvent (S) is used, for example, in an amount such that the solid content concentration of the photosensitive resin composition is preferably 40% by mass or more and 70% by mass or less, and more preferably 50% by mass or more and 65% by mass or less from the viewpoint of the manufacturing step of a margin of the etching processing, and the like. On both sides of the two main surfaces of the glass substrate mentioned below, in the step of applying a photosensitive resin composition from the vertical upper side toward the vertical lower side using a contact type coater, the viscosity of the photosensitive resin composition is preferably adjusted to 1000 cp or more, more preferably 1400 cp or more, and further preferably 2000 cp or more. The upper limit is not particularly limited as long as the photosensitive resin composition has fluidity. Examples thereof includes 30000 or less, 10000 or less, and the like.

### [Other components]

The photosensitive resin composition may include various components that have conventionally been blended in the positive-type photosensitive composition.

For example, the photosensitive resin composition may further contain a surfactant for improving coating, defoaming, leveling, and the like. As the surfactant, for example, a fluorinated surfactant and a silicone surfactant are preferably used. Specific examples of the fluorinated surfactant include commercially available fluorochemical surfactants such as BM-1000 and BM-1100 (both manufactured by Bodo Möller Chemie GmbH), Megafac F142D, Megafac F172, Megafac F173 and Megafac F183 (all manufactured by DIC Corporation), Flolade FC-135, Flolade FC-170C, Flolade FC-430 and Flolade FC-431 (all manufactured by Sumitomo 3M Ltd.), Surflon S-112, Surflon S-113, Surflon S-131, Surflon S-141 and Surflon S-145 (all manufactured by AGC Inc.), SH-28PA, SH-190, SH-193, SZ-6032 and SF-8428 (all manufactured by Toray Silicone Co., Ltd.), but there is no limitation to those. As the silicone surfactant, a non-modified silicone surfactant, a polyether modified silicone surfactant, a polyester modified silicone surfactant, an alkyl modified silicone surfactant, an aralkyl modified silicone surfactant, a reactive silicone surfactant and the like can be preferably used. As the silicone surfactant, a commercially available silicone surfactant can be used. Specific examples of the commercially available silicone surfactant include Paintad M (manufactured by Dow Corning Toray Co., Ltd.), TOPICA K1000, TOPICA K2000 and TOPICA K5000 (all of which are manufactured by Takachiho Sangyo Co., Ltd.), XL-121 (polyether modified silicone surfactant, manufactured by Clariant), BYK-088 (silicone defoaming agent, manufactured by BYK-Chemie GmbH) (BYK-310 (polyester modified silicone surfactant, manufactured by BYK-Chemie GmbH), and the like.

Furthermore, in order to finely adjust the solubility in a developing solution, the photosensitive resin composition may further contain an acid, or an acid anhydride.

Specific examples of the acid and acid anhydride can include monocarboxylic acids such as acetic acid, propionic acid, n-butyric acid, isobutyric acid, n-valeric acid, isovaleric acid, benzoic acid, and cinnamic acid; hydroxymonocarboxylic acids such as lactic acid, 2-hydroxybutyric acid, 3-hydroxybutyric acid, salicylic acid, m-hydroxybenzoic acid, p-hydroxybenzoic acid, 2-hydroxycinnamic acid, 3-hydroxycinnamic acid, 4-hydroxycinnamic acid, 5-hydroxyisophthalic acid, and syringic acid; polyvalent carboxylic acids such as oxalic acid, succinic acid, glutaric acid, adipic acid, maleic acid, itaconic acid, hexahydrophthalic acid, phthalic acid, isophthalic acid, terephthalic acid, 1,2-cyclohexanedicarboxylic acid, 1,2,4-cyclohexanetricarboxylic acid, butanetetracarboxylic acid, trimellitic acid, pyromellitic acid, cyclopentanetetracarboxylic acid, butanetetracarboxylic acid, and 1,2,5,8-naphthalenetetracarboxylic acid; acid anhydrides such as itaconic anhydride, succinic anhydride, citraconic anhydride, dodecenylsuccinic anhydride, tricarbanilic anhydride, maleic anhydride, hexahydrophthalic anhydride, methyltetrahydrophthalic anhydride, Himic anhydride, 1,2,3,4-butanetetracarboxylic acid, cyclopentanetetracarboxylic dianhydride, phthalic anhydride, pyromellitic anhydride, trimellitic anhydride, benzophenonetetracarboxylic anhydride, ethylene glycol bis anhydrous trimellitate, and glycerin tris anhydrous trimellitate; and the like.

The above-described components are uniformly mixed in a desired ratio to obtain a first photosensitive resin composition.

### <Second photosensitive resin composition>

As described above, the second photosensitive resin composition not falling within the subject-matter of the appended set of claims includes a resin component (A1) having a phenolic hydroxyl group, a protective agent (A2) giving an acid-dissociable dissolution-inhibiting group by reacting with the phenolic hydroxyl group, an acid generator (B), a filler (C), and a plasticizer (D). The acid generator (B), the filler (C), the plasticizer (D), and other components are the same as those in the first photosensitive resin composition.

Hereinafter, for the second photosensitive resin composition not falling within the subject-matter of the appended set of claims, the resin component (A1) having a phenolic hydroxyl group and the protective agent (A2) giving an acid-dissociable dissolution-inhibiting group by reacting with a phenolic hydroxyl group are described.

### [Resin component (A1) having phenolic hydroxyl group]

A resin component (A1) having a phenolic hydroxyl group is a novolac resin or a polyhydroxystyrene resin in which at least a part of the phenolic hydroxyl group may be protected by the acid-dissociable dissolution-inhibiting group. The novolac resin or a polyhydroxystyrene resin having a phenolic hydroxyl group in which at least a part of the phenolic hydroxyl group is protected by the acid-dissociable dissolution-inhibiting group is the same as the resin component (A) described for the first photosensitive resin composition. As the novolac resin and the polyhydroxystyrene resin, the novolac resin and the polyhydroxystyrene resin in a state in which the phenolic hydroxyl group protected by the acid-dissociable dissolution-inhibiting group is deprotected can be used in the resin component (A) described in the first photosensitive resin composition. The mass average molecular weight of the resin component (A1) is preferably 1000 or more and 60000 or less, and more preferably 2000 or more and 50000 or less. These resin components (A1) may be used alone or in combinations of two or more thereof. The content of the resin component (A1) is preferably 5% by mass or more and 90% by mass or less, more preferably 15% by mass or more and 80% by mass or less, and further preferably 30% by mass or more and 70% by mass or less relative to the solid content (excluding a solvent) of the second radiation sensitive composition.

### [Protective agent (A2)]

The protective agent (A2) is a compound giving an acid-dissociable dissolution-inhibiting group by reacting with a phenolic hydroxyl group. The protective agent (A2) is not particularly limited as long as it is a compound giving an acid-dissociable dissolution-inhibiting group by reacting with a phenolic hydroxyl group such as a methoxyethyl group, an ethoxyethyl group, an n-propoxyethyl group, an isopropoxyethyl group, an n-butoxyethyl group, isobutoxyethyl group, a tert-butoxyethyl group, a cyclohexyloxyethyl group, a methoxypropyl group, an ethoxypropyl group, a 1-methoxy-1-methyl-ethyl group, a 1-ethoxy-1-methylethyl group, a tert-butoxy carbonyl group, a tert-butoxy carbonyl methyl group, a trimethylsilyl group, and a tri-tert-butyl dimethyl silyl group, which are described for the first photosensitive resin composition.

From the viewpoint that excellent resistance of an etching mask to an etchant and easiness in peeling of the etching mask by an organic solvent are both easily achieved, the protective agent is preferably a divinyl ether compound represented by the above-described formula (I).

The amount of protective agent (A2) used is preferably in a range of 0.5 parts by mass or more and 30 parts by mass or less, more preferably 1 part by mass or more and 20 parts by mass or less, and further preferably 2 parts by mass or more and 10 parts by mass or less with respect to 100 parts by mass of the resin component (A1) having a phenolic hydroxyl group, from the viewpoint of the film characteristics of the etching mask.

The above-described components are uniformly mixed in a desired ratio to obtain a second photosensitive resin composition not falling within the subject-matter of the appended set of claims.

### <<Method for etching glass substrate>>

A method for etching a glass substrate is a method including: a coating film formation step of applying the above-described photosensitive resin composition to at least one of main surfaces of the glass substrate to form a coating film on the main surface of the glass substrate; an exposure step of exposing the coating film in a position-selective manner; an etching mask formation step of developing the exposed coating film with a developing solution to form an etching mask; an etching step of subjecting the glass substrate provided with the etching mask to etching processing; and a removing step of removing the etching mask.

Hereinafter, each step of the method for etching the glass substrate will be described.

### <Coating film formation step>

In the coating film formation step, the above-described photosensitive resin composition is applied to at least one main surface of the glass substrate to be etched so as to form a coating film on the main surface of the glass substrate. Types of the glass substrate are not particularly limited, and examples thereof include non-alkali glass, borosilicate glass, tempered glass, quartz, and the like. Furthermore, the shapes of the glass substrate are not particularly limited. The shape of the glass substrate may be an uneven shape or a shape having a through-hole.

The dipping depth of the glass substrate by etching processing is not particularly limited. When the glass substrate is etching-processed from both surfaces of the main surface, the dipping depth is a total of the dipping depths of both main surfaces of the glass substrate. By forming an etching mask using the photosensitive resin composition of the present invention, the dipping depth of the glass substrate by etching processing can be made as deep as, for example, about 2000 um. The lower limit value in a range of the processing of the dipping depth can be appropriately set. In view of the above-mentioned dipping depth, the thickness of the glass substrate is preferably 10 um or more, more preferably 200 um or more and 3000 um or less, further preferably 250 um or more and 2300 um or less, and particularly preferably 300 um or more and 2000 um or less.

The film thickness of the etching mask is not particularly limited as long as the etching processing can be carried out without any problems. Typically, the film thickness of the etching mask is preferably 5 um or more and 200 um or less, more preferably 10 um or more and 150 um or less, further preferably 30 um or more and 100 um or less, and particularly preferably 50 um or more and 80 um or less. Furthermore, it is preferably 5 um or more and 200 um or less in application for both surfaces. Furthermore, the film thickness of an etching mask is preferably 0.08 times or more and 0.25 times or less, and more preferably 0.1 times or more and 0.2 times or less with respect to the dipping depth by etching processing of the glass substrate.

In the coating film forming step, the above-described photosensitive resin composition can be applied onto a glass substrate using, for example, a contact transfer type coating device such as a roll coater, a reverse coater, or a bar coater, or a non-contact type coating device such as a spinner, a curtain flow coater, or a slit coater to form a coating film. The formed coating film may be heated (prebaked) as necessary.

Although the conditions for the pre-baking differ depending on the types of components in the photosensitive resin composition, the mixing ratio, the thickness of the coating film and the like, the conditions are that the pre-baking is performed normally at 70°C or more and 200°C or less and preferably at 80°C or more and 150°C or less for about 2 minutes or more and 120 minutes or less.

For example, when a glass substrate having a thickness of 200 um or more is cut by etching processing, or by forming a through-hole by etching processing of the glass substrate having a thickness of 200 um or more, etching time can be shortened, so that damage to an etching mask can be suppressed. Thus, etching is carried out by bringing an etchant into contact with both main surfaces of the glass substrate. When etching is carried out by bringing an etchant into contact with both main surfaces of the glass substrate, the etching mask is formed on both main surfaces of the glass substrate.

When a photosensitive resin composition is applied to both main surfaces of the glass substrate, from the viewpoint that a coating film having a uniform film thickness can be formed, it is preferable that the photosensitive resin composition is applied from the vertical upper side to the vertical lower side on both main surfaces of the glass substrate using a contact type coating device, in a state in which the glass substrate is located such that the main surface of the glass substrate is in a direction perpendicular to the vertical direction or the substantially vertical direction. Note here that the photosensitive resin composition can also be applied by a contact type coating device on both of the two main surfaces of the glass substrate, in a state in which the glass substrate is located such that the surface direction of the main surface of the glass substrate is the horizontal direction or substantially the horizontal direction.

When the application is carried out to both surfaces as mentioned above, a contact-type coating device may be moved to carry out application with a position of the glass substrate fixed, or the glass substrate may be moved to carry out application with the position of the contact-type coating device fixed.

When the application is carried out to both surfaces as mentioned above, as the coating device, contact transfer type coating devices such as a roll coater, a reverse coater, a bar coater, and the like, are preferably used, and a roll coater is more preferably used.

### <Exposure step>

In the exposure step, a coating film on the glass substrate is exposed in a position-selective manner according to the shape of the etching mask to be formed. Specifically, a coating film is selectively irradiated (exposed) with an active ray or radiation, for example, ultraviolet radiation or visible light with a wavelength of 300 nm or more and 500 nm or less through a mask having a predetermined pattern.

Low pressure mercury lamps, high pressure mercury lamps, super high pressure mercury lamps, metal halide lamps, argon gas lasers, etc. can be used as a radiation source. The radiation may include micro waves, infrared rays, visible light, ultraviolet rays, X-rays, γ-rays, electron beams, proton beams, neutron beams, ion beams, and the like. The irradiation dose of the radiation may vary depending on the constituent of the photosensitive composition, the film thickness of the photosensitive layer, and the like. For example, when a super high pressure mercury lamp is used, the dose may be 100 mJ/cm² or more and 10000 mJ/cm² or less.

After exposure, the diffusion of acid is promoted by heating the coating film using a well-known method to change the solubility of the coating film to a developing solution such as an alkali developing solution at the exposed portion in the coating film.

### <Etching mask formation step>

In the etching mask formation step, the exposed coating film is developed with a developing solution to form an etching mask.

As the developing solution, an aqueous solution of an alkali such as, for example, sodium hydroxide, potassium hydroxide, sodium carbonate, sodium silicate, sodium metasilicate, aqueous ammonia, ethylamine, n-propylamine, diethylamine, di-n-propylamine, triethylamine, methyldiethylamine, dimethylethanolamine, triethanolamine, tetramethylammonium hydroxide, tetraethylammonium hydroxide, pyrrole, piperidine, 1,8-diazabicyclo[5,4,0]-7-undecene, and 1,5-diazabicyclo[4,3,0]-5-nonane can be used. Also, an aqueous solution prepared by adding an adequate amount of a watersoluble organic solvent such as methanol or ethanol or a surfactant to the aqueous solution of the alkali can be used as the developing solution.

The developing time may vary depending on the composition of the photosensitive resin composition, the film thickness of the coating film, and the like. Usually, the developing time is 1 minute or more and 30 minutes or less. The developing method may be any one of a liquid-filling method, a dipping method, a paddle method, a spray developing method, and the like.

After development, washing with running water for 30 seconds or more and 90 seconds or less and drying with an air gun, an oven, and the like are carried out as necessary. In this way, an etching mask patterned in a desired shape is formed on the glass substrate.

### <Etching step>

In the etching step, etching processing is performed to a glass substrate provided with an etching mask.

The etching processing may be cutting a glass substrate or forming a hole penetrating through the glass substrate in the thickness direction thereof, or may be a process of forming grooves or trenches in the glass substrate.

The etching method is not particularly limited as long as the method can bring an etchant into contact with a glass substrate. Examples of the etching method include wet etching such as spraying an etchant to a glass substrate and immersing a glass substrate into an etchant. Etching may be carried out by bringing an etchant into contact with only one main surface of the glass substrate or bringing an etchant into contact with both main surfaces of the glass substrate.

When an etchant is brought into contact with only one main surface of the glass substrate, a main surface that is not brought into contact with the glass substrate is preferably covered with a protective film. The protective film is not particularly limited as long as it has resistance to an etchant. The protective film may be formed by attaching a sheet made of material having resistance to an etchant to a glass substrate or may be formed by applying the above-described photosensitive resin composition followed by heating a coating film.

As described above, when a glass substrate having a thickness of 200 um or more is cut by etching processing or by forming through-holes by etching processing of a glass substrate having a thickness of 200 um or more, it is preferable to carry out etching by bringing an etchant into contact with both main surfaces of the glass substrate because etching time can be shortened and damage to an etching mask can be suppressed.

Examples of the etchant include hydrofluoric acid alone, an acid mixture of hydrofluoric acid and ammonium fluoride, an acid mixture of hydrofluoric acid and other acids (hydrochloric acid, sulfuric acid, phosphoric acid, nitric acid, etc.), or the like. The etching treatment time is not particularly limited, and is, for example, about 10 minutes to 10 hours. Note here that the etchant may be warmed to about 25°C or more and 60°C or less. Furthermore, the concentration of the etching treatment liquid may be appropriately adjusted by considering an etching rate or treatment time. For example, the concentration of hydrofluoric acid is preferably 1% by mass or more and 20% by mass or less, and more preferably 5% by mass or more and 10% by mass or less. The concentration of other acids is preferably 1% by mass or more and 40% by mass or less, and more preferably 1% by mass or more and 20% by mass or less.

### <Removing step>

Following the etching processing, in the removing step, an etching mask is removed from a glass substrate.

A method for removing an etching mask is not particularly limited, but a method of bringing the etching mask into contact with an organic solvent is preferable because the glass substrate, metal wiring accompanying the glass substrate, and resin material are hardly damaged. The method of bringing the etching mask into contact with the organic solvent is not particularly limited. For example, an organic solvent may be sprayed to an etching mask, or a glass substrate provided with an etching mask may be immersed in an organic solvent.

The organic solvent is not particularly limited as long as it can remove an etching mask, and it may be appropriately selected from the above-mentioned solvents (S). The organic solvent is preferably a polar solvent (in particular, ketones or monoethers of glycols in the above-mentioned solvent (S)), from the viewpoint of the process after the removing step. From the viewpoint of a margin of the removing step, preferable examples thereof include aprotic polar organic solvents such as N-methylformamide, N,N-dimethylformamide, N-methylformanilide, N-methylacetamide, N,N-dimethylacetamide, N-methyl-2-pyrrolidone, dimethylsulfoxide, and the like. Two or more types of these organic solvents may also be used in combination.

The temperature of the organic solvent to be used for peeling of the etching mask is not particularly limited. In order to improve the peelability, heating may be performed. The temperature of the organic solvent is, for example, preferably 5°C or more and 80°C or less, preferably 10°C or more and 50°C or less, and further preferably 20 °C or more and 25°C or less in view of the effect on a glass substrate, metal wiring, and resin material accompanying a glass substrate.

The contact time of the etching mask and the organic solvent is not particularly limited as long as peeling of the etching mask can be carried out satisfactorily. The contact time is, for example, preferably 1 minute or more and 60 minutes or less, and more preferably 1 minute or more and 15 minutes or less.

### EXAMPLES

Hereinafter, the present invention is described in more detail by way of Examples, but the present invention is not limited to these Examples.

### [Examples 1 to 4]

Components in ratios described in the following Table were mixed to obtain photosensitive resin compositions. A use amount of each component described in Table 1 is described as part by mass. The following components in Table 1 are as follows. Furthermore, the viscosity of the composition of each example was about 1500 cp in Examples 1 to 4. The viscosity was about 2000 cp in Examples 5 to 7. The viscosity was a measurement value at 25°C measured using an E-type viscometer.

**[Table 1]**

| | | Example | | | | | | |
|---|---|---|---|---|---|---|---|---|
| | | 1 | 2 | 3 | 4 | 5 | 6 | 7 |
| Resin component (A) | (A)-1 | 100 | 100 | 100 | | 100 | 100 | 100 |
| | (A)-2 | | | | 30 | | | |
| | (A)-3 | | | | 50 | | | |
| Protective agent(A2) | (A2)-1 | | | | | 1 | 2 | 10 |
| Acid generator (B) | (B)-1 | 0.3 | 0.3 | 0.3 | 0.3 | 0.3 | 0.3 | 0.3 |
| | (B)-2 | 1.5 | | | 1.5 | 1.5 | 1.5 | 1.5 |
| | (B)-3 | | 1.5 | | | | | |
| | (B)-4 | | | 1.5 | | | | |
| Filler (C) | (C)-1 | 55 | 55 | 55 | 55 | 55 | 55 | 55 |
| Plasticizer(D) | (D)-1 | 15 | 15 | 15 | 15 | 30 | 30 | 30 |
| Solvent(S) | (S)-1 | 120 | 120 | 120 | 120 | 120 | 120 | 120 |
| | (S)-2 | 40 | 40 | 40 | 40 | 40 | 40 | 40 |
| | (S)-3 | 15 | 15 | 15 | 15 | 15 | 15 | 15 |
| Other additives (O) | (O)-1 | 0.2 | 0.2 | 0.2 | 0.2 | 0.2 | 0.2 | 0.2 |
| | (O)-2 | | | | | 2 | 2 | 2 |
| Viscosity | | 1500cp | 1500cp | 1500cp | 1500cp | 2000cp | 2000cp | 2000cp |
| Residues after removing mask | | Not observed | Not observed | Not observed | Not observed | Not observed | Not observed | Not observed |
| Effect on wiring etc. | | None | None | None | None | None | None | None |

### <Resin component (A)>

(A)-1: Novolac resin in which 7.5% of all phenolic hydroxyl group is protected by an acid-dissociable dissolution-inhibiting group derived from 1,4-cyclohexanedimethanol divinyl ether. (Mw: 40000, m-cresol/p-cresol = 6/4 (molar ratio) for novolac resin before protection.)
(A)-2: Novolac resin in which 15% of all phenolic hydroxyl group is protected by an acid-dissociable dissolution-inhibiting group derived from 1,4-cyclohexanedimethanol divinyl ether. (Mw: 15000, m-cresol/p-cresol = 6/4 (molar ratio) for novolac resin before protection.)
(A)-3: Novolac resin in which 6% of all phenolic hydroxyl group is protected by an acid-dissociable dissolution-inhibiting group derived from 1,4-cyclohexanedimethanol divinyl ether. (Mw: 25000, m-cresol/p-cresol = 6/4 (molar ratio) for novolac resin before protection.)

### <Protective agent (A2)>

(A2)-1: 1,4-cyclohexanedimethanol divinyl ether

### <Acid generator (B)>

(B)-1: Triphenylsulfonium nonafluorobutane sulfonate
(B)-2: Compound of the following formula 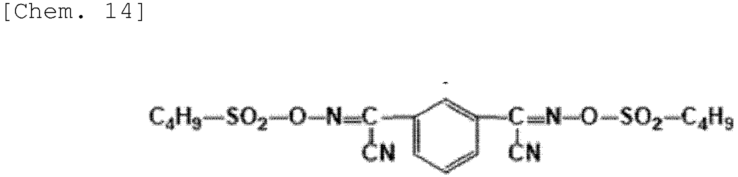
(B)-3: 2,4-bis(trichloromethyl)-6-piperonyl-1,3,5-triazine
(B)-4: Compound of the following formula

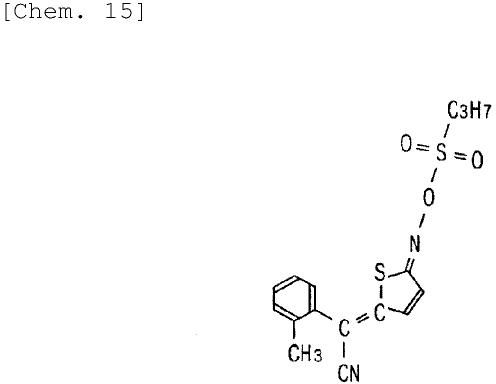

### <Filler (C)>

(C)-1: Barium sulfate powder

### <Plasticizer (D)>

(D)-1: Polyvinyl methyl ether (mass average molecular weight: 100000)

### <Solvent (S)>

(S)-1: Propylene glycol monomethyl ether acetate
(S)-2: Butyl acetate
(S)-3: Methoxybutyl acetate

### <Other additives (0)>

(O)-1: 0.1 part by mass of tri-n-decylamine, and 0.1 part by mass of surfactant (product name: XR-104 manufactured by DIC Corporation)
(O)-2: Silicone-based defoaming agent (product name: BYK-088, manufactured by BYK-Chemie GmbH)

### <Evaluation 1>

An etching mask was formed on a glass substrate using each of the obtained photosensitive resin compositions of Examples 1 to 4 according to the following method. Firstly, a photosensitive resin composition was applied to a glass substrate having a thickness of 400 um and being partially provided with a polyimide film and metal wiring. Next, the coating film was heated at 90°C for three minutes, and then heated at 150°C for three minutes. The coating film after heating was exposed through a positive-type mask at an exposure amount of 1200 mJ/cm². The coating film after exposure was heated at 115°C for three minutes. The coating film after heating was brought into contact with tetramethylammonium hydroxide aqueous solution of 22°C having a concentration of 2.38% by mass for seven minutes, and developed. The developed coating film was heated at 120°C for 60 minutes to form an etching mask having a thickness of 70 um. The glass substrate provided with the etching mask was etched at room temperature in the following conditions.
- Etching treatment liquid (1:1 acid mixture solution of 10% by mass aqueous solution of hydrofluoric acid and 20% by mass aqueous solution of nitric acid)
- Etching time: 1 hour

When the glass substrate after etching was immersed in a mixed solvent of N-methyl-2-pyrrolidone (NMP) and dimethyl sulfoxide (DMSO) (NMP/DMSO (mass ratio) = 40/60) at room temperature, the etching mask was completely removed by dissolving in less than 10 minutes. When the surface of the glass substrate from which the etching mask had been removed was observed under a microscope, and residue after having removed the etching mask was not observed on the glass substrate. Also, film loss of the polyimide film and damage to metal wiring were not observed.

### <Evaluation 2>

An etching mask was formed on a glass substrate using each of the obtained photosensitive resin compositions of Examples 5 to 7 according to the following method. Firstly, a photosensitive resin composition was applied at a thickness of 70 um on a glass substrate having a thickness of 400 um and being partially provided with the polyimide film and metal wiring and dried by heating at 90°C for three minutes. Next, using the same photosensitive resin composition, the dried coating film was subjected to second application and drying (90°C for three minutes) to obtain a coating film having a film thickness of 140 um. Thereafter, the coating film was heated at 150°C for three minutes. The coating film after drying (heating) was exposed through a positive-type mask at an exposure amount of 1200 mJ/cm². The coating film after exposure was heated at 115°C for three minutes. The coating film after heating was brought into contact with tetramethylammonium hydroxide aqueous solution of 22°C and having a concentration of 2.38% by mass for seven minutes, and developed. The developed coating film was heated at 120°C for 60 minutes to form an etching mask having a thickness of 140 um. The obtained etching mask was observed under an ultrasonic microscope (C-SAM D9600), and the etching mask was free from pin-holes and cracks. The glass substrate provided with an etching mask was etched at room temperature under the following conditions.
- Etching treatment liquid (1:1 acid mixture solution of 10% by mass aqueous solution of hydrofluoric acid and 20% by mass aqueous solution of nitric acid)
- Etching time: 1 hour

When the glass substrate after etching was immersed in a mixed solvent of N-methyl-2-pyrrolidone (NMP) and dimethyl sulfoxide (DMSO) (NMP/DMSO (mass ratio) = 40/60) at room temperature, the etching mask was completely removed by dissolving in less than 10 minutes. The surface of the glass substrate from which the etching mask had been removed was observed under a microscope, and residue after having removed the etching mask was not observed on the glass substrate. Also, film loss of the polyimide film and damage to metal wiring were not observed.

### [Comparative Example]

### <Evaluation of Peelability>

Application, exposure, and development were carried out using commercially available negative-type photosensitive composition according to a routine procedure to form an etching mask having a thickness of 70 um on a glass substrate having a thickness of 400 um and being partially provided with a polyimide film and metal wiring. After the same etching treatment as in the Examples was carried out, when a glass substrate provided with an etching mask was immersed in a mixed solvent of N-methyl-2-pyrrolidone (NMP) and dimethyl sulfoxide (DMSO) (NMP/DMSO (mass ratio) = 40/60) at room temperature, immersion for 10 minutes was unable to remove the etching mask. Furthermore, when a glass substrate provided with an etching mask was immersed in a mixed solvent of monoethanolamine (MEA) and dimethyl sulfoxide (DMSO) (MEA/DMSO (mass ratio) = 70/30) at 50°C for 30 minutes, the etching mask was removed, but a large amount of residue after removing was generated. Furthermore, in the polyimide film, film loss was observed and corrosion was seen in the metal wiring.

## Claims

1. A photosensitive resin composition comprising:
a resin component (A) having an acid-dissociable dissolution-inhibiting group and having a solubility in alkali to be increased by an action of an acid, an acid generator (B) to generate an acid by irradiation with radiation, a filler (C), and a plasticizer (D),
wherein the resin component (A) is a novolac resin in which at least a part of the phenolic hydroxyl group is protected by the acid-dissociable dissolution-inhibiting group,,
the resin component (A) comprises a reacted product of the novolac resin and a compound represented by the formula (I),
the formula (I) is represented by the following formula:
H₂C=CH-O-A^{a1}-O-CH=CH₂ ... (I)
wherein, in the formula (I), A^{a1} is an alkylene group having 1 or more and 10 or less carbon atoms, optionally having a substituent and optionally having an ether bond in a main chain, or a group represented by the following formula (II):
-(A^{a2})ₙₐ-A^{a3}-(A^{a2})ₙₐ- ... (II)
wherein, in the formula (II), A^{a2} is an alkylene group having 1 or more and 10 or less carbon atoms, and optionally having a substituent, A^{a3} is a cyclohexylene group, and na is 0 or 1,
the filler (C) comprises an inorganic filler or an organic filler, and
the plasticizer (D) comprises a polyvinylalkyl ether.

2. The photosensitive resin composition according to claim 1 used for forming an etching mask on a glass substrate.

3. The photosensitive resin composition according to any one of claims 1 or 2, comprising a solvent (S), wherein the solvent (S) comprises a high boiling-point solvent (S1) having a boiling point under atmospheric pressure of 170°C or more.

4. A method for etching a glass substrate, the method comprising:
a coating film formation step of applying the photosensitive resin composition according to any one of claims 1 to 3 to at least one of main surfaces of the glass substrate to form a coating film on the main surface of the glass substrate;
an exposure step of exposing the coating film in a positionselective manner;
an etching mask formation step of developing the exposed coating film with a developing solution to form an etching mask;
an etching step of subjecting the glass substrate provided with the etching mask to etching processing; and
a removing step of removing the etching mask.

5. The method according to claim 4, wherein the etching processing is a hole-forming processing of forming a hole penetrating through the glass substrate in a thickness direction of the glass substrate.

6. The method according to claim 4 or 5, comprising:
forming the etching mask on both of two main surfaces of the glass substrate, and
subjecting the both two main surfaces of the glass substrate to the etching processing.

7. Use of the photosensitive resin composition according to any one of claims 1 to 3 for forming an etching mask on a glass substrate.

## Patentansprüche

1. Lichtempfindliche Harzzusammensetzung, umfassend:
eine Harzkomponente (A), die eine säuredissoziierbare auflösungsinhibierende Gruppe aufweist und eine Löslichkeit in Alkali aufweist, die durch die Einwirkung einer Säure erhöht wird, einen Säuregenerator (B), um eine Säure durch Bestrahlung mit Strahlung zu erzeugen, einen Füllstoff (C) und einen Weichmacher (D),
wobei die Harzkomponente (A) ein Novolakharz ist, in dem mindestens ein Teil der phenolischen Hydroxylgruppe durch die säuredissoziierbare auflösungsinhibierende Gruppe geschützt ist,
die Harzkomponente (A) ein Reaktionsprodukt des Novolakharzes und eine Verbindung, die durch die Formel (I) dargestellt ist, umfasst,
wobei die Formel (I) durch die folgende Formel dargestellt ist:
H₂C=CH-O-A^{a1}-O-CH=CH₂ ••• (I)
wobei in der Formel (I) A^{a1} eine Alkylengruppe ist, die 1 oder mehr und 10 oder weniger Kohlenstoffatome aufweist, die gegebenenfalls einen Substituenten aufweist und gegebenenfalls eine Etherbindung in einer Hauptkette aufweist, oder eine Gruppe, dargestellt durch die folgende Formel (II):
-(A^{a2})ₙₐ-A^{a3}-(Aa²)ₙₐ- ••• (II)
wobei in der Formel (II) A^{a2} eine Alkylengruppe ist, die 1 oder mehr und 10 oder weniger Kohlenstoffatome aufweist, und gegebenenfalls einen Substituenten aufweist, A^{a3} eine Cyclohexylengruppe ist, und na 0 oder 1 ist,
der Füllstoff (C) einen anorganischen Füllstoff oder einen organischen Füllstoff umfasst, und
der Weichmacher (D) einen Polyvinylalkylether umfasst.

2. Lichtempfindliche Harzzusammensetzung nach Anspruch 1, die verwendet wird, um eine Ätzmaske auf einem Glassubstrat zu bilden.

3. Lichtempfindliche Harzzusammensetzung nach einem beliebigen der Ansprüche 1 oder 2, umfassend ein Lösungsmittel (S), wobei das Lösungsmittel (S) ein hochsiedendes Lösungsmittel (S1) umfasst, das einen Siedepunkt unter Atmosphärendruck von 170 °C oder mehr aufweist.

4. Verfahren zum Ätzen eines Glassubstrats, wobei das Verfahren umfasst:
einen Schritt zum Bilden eines Beschichtungsfilms zum Auftragen der lichtempfindlichen Harzzusammensetzung gemäß einem beliebigen der Ansprüche 1 bis 3 auf mindestens eine der Hauptoberflächen des Glassubstrats, um einen Beschichtungsfilm auf der Hauptoberfläche des Glassubstrats zu bilden;
einen Belichtungsschritt zum Belichten des Beschichtungsfilms in einer positionsselektiven Weise;
einen Schritt zum Bilden einer Ätzmaske zum Entwickeln des belichteten Beschichtungsfilms mit einer Entwicklungslösung, um eine Ätzmaske zu bilden;
einen Ätzschritt, bei dem das mit der Ätzmaske bereitgestellte Glassubstrat einem Ätzvorgang unterzogen wird; und
einen Entfernungsschritt zum Entfernen der Ätzmaske.

5. Verfahren nach Anspruch 4, wobei der Ätzvorgang ein Lochbildungsvorgang ist, bei dem ein Loch gebildet wird, das durch das Glassubstrat in einer Dickenrichtung des Glassubstrats hindurchgeht.

6. Verfahren nach Anspruch 4 oder 5, umfassend:
Bilden der Ätzmaske auf beiden von zwei Hauptoberflächen des Glassubstrats, und
Unterziehen der beiden Hauptoberflächen des Glassubstrats dem Ätzprozess.

7. Verwendung der lichtempfindlichen Harzzusammensetzung nach einem beliebigen der Ansprüche 1 bis 3 zum Bilden einer Ätzmaske auf einem Glassubstrat.

## Revendications

1. Composition de résine photosensible comprenant :
un composant de résine (A) ayant un groupe inhibiteur de dissolution dissociable par un acide et ayant une solubilité dans les alcalins à augmenter par une action d'un acide,
un générateur d'acide (B) pour générer un acide par irradiation avec un rayonnement,
une charge (C), et un plastifiant (D),
dans laquelle le composant de résine (A) est une résine novolaque dans laquelle au moins une partie du groupe hydroxyle phénolique est protégée par le groupe inhibiteur de dissolution dissociable par un acide,
le composant de résine (A) comprend un produit issu de la réaction de la résine novolaque et d'un composé représenté par la formule (I),
la formule (I) est représentée par la formule suivante :
H₂C=CH-O-A^{a1}-O-CH=CH₂ (I)
dans laquelle, dans la formule (I), A^{a1} est un groupe alkylène ayant 1 ou plus et 10 ou moins atomes de carbone, ayant facultativement un substituant et ayant facultativement une liaison éther dans une chaîne principale, ou un groupe représenté par la formule (II) suivante :
-(A^{a2})ₙₐ-A^{a3}-(A^{a2})ₙₐ- (II)
dans laquelle, dans la formule (II), A^{a2} est un groupe alkylène ayant 1 ou plus et 10 ou moins atomes de carbone, et ayant facultativement un substituant, A^{a3} est un groupe cyclohexylène, et na est 0 ou 1,
la charge (C) comprend une charge inorganique ou une charge organique, et
le plastifiant (D) comprend un polyvinylalkyléther.

2. Composition de résine photosensible selon la revendication 1 utilisée pour former un masque de gravure sur un substrat de verre.

3. Composition de résine photosensible selon l'une quelconque des revendications 1 ou 2, comprenant un solvant (S), dans laquelle le solvant (S) comprend un solvant à point d'ébullition élevé (S1) ayant un point d'ébullition sous pression atmosphérique de 170 °C ou plus.

4. Procédé de gravure d'un substrat de verre, le procédé comprenant :
une étape de formation de film de revêtement consistant à appliquer la composition de résine photosensible selon l'une quelconque des revendications 1 à 3 sur au moins l'une des surfaces principales du substrat de verre pour former un film de revêtement sur la surface principale du substrat de verre ;
une étape d'exposition consistant à exposer le film de revêtement d'une manière sélective par rapport à la position ;
une étape de formation de masque de gravure consistant à développer le film de revêtement exposé avec une solution de développement pour former un masque de gravure ;
une étape de gravure consistant à soumettre le substrat de verre doté du masque de gravure à un traitement de gravure ; et
une étape de retrait consistant à retirer le masque de gravure.

5. Procédé selon la revendication 4, dans lequel le traitement de gravure est un traitement de formation de trou consistant à former un trou pénétrant à travers le substrat de verre dans une direction d'épaisseur du substrat de verre.

6. Procédé selon la revendication 4 ou 5, comprenant :
la formation du masque de gravure sur les deux surfaces principales du substrat de verre, et
la soumission des deux surfaces principales du substrat de verre au traitement de gravure.

7. Utilisation de la composition de résine photosensible selon l'une quelconque des revendications 1 à 3 pour former un masque de gravure sur un substrat de verre.
